Europäisches Patentamt

European Patent Office

Office européen des brevets

(19)

(11) Numéro de publication : **0 490 711 B1**

(12)

# FASCICULE DE BREVET EUROPEEN

(45) Date de publication du fascicule du brevet :
**15.03.95 Bulletin 95/11**

(51) Int. Cl.⁶ : **G01R 35/04,** G01R 15/00

(21) Numéro de dépôt : **91402800.6**

(22) Date de dépôt : **22.10.91**

(54) **Dispositif de mesure électrique à double configuration de branchement.**

(30) Priorité : **07.12.90 FR 9015332**

(43) Date de publication de la demande :
**17.06.92 Bulletin 92/25**

(45) Mention de la délivrance du brevet :
**15.03.95 Bulletin 95/11**

(84) Etats contractants désignés :
**AT BE CH DE DK ES FR GB GR IT LI NL SE**

(56) Documents cités :
**DE-A- 2 832 656**
**FR-A- 2 391 474**
**FR-A- 2 625 323**

(73) Titulaire : **SCHLUMBERGER INDUSTRIES**
**50, avenue Jean Jaurès**
**F-92120 Montrouge (FR)**

(72) Inventeur : **Clarke, David John**
**The Grove Packard Place**
**Bramford Ipswich Suffolk IP84HA (GB)**
Inventeur : **Patry, Bernard**
**24, Avenue Parrat**
**F-91400 Orsay (FR)**
Inventeur : **Chiffert, Alain**
**2, rue Ferdinand Boire**
**F-91300 Massy (FR)**
Inventeur : **Carnel, Alain**
**162, Bld. des Rocs**
**F-86000 Poitiers (FR)**

(74) Mandataire : **Bentz, Jean-Paul**
**SCHLUMBERGER INDUSTRIES**
**Propriété Intellectuelle**
**Groupe Electricité**
**B.P. 620-02**
**F-92542 Montrouge Cédex (FR)**

## Description

La présente invention concerne un dispositif de mesure électrique comprenant :

- au moins N+1 bornes de branchement dont les potentiels, en fonctionnement, définissent au moins N tensions pilotes, N étant un entier au moins égal à un;
- un circuit électronique de mesure comportant au moins N+1 bornes d'entrée dont les potentiels, en fonctionnement, définissent pour ce circuit au moins N tensions images représentatives de tensions pilotes correspondantes, ce circuit utilisant un potentiel de référence lié au potentiel de la première borne de branchement; et
- un premier diviseur de tension, installé entre les première et seconde bornes de branchement, comportant un premier point intermédiaire relié à la seconde borne d'entrée du circuit de mesure, et introduisant un rapport déterminé de tensions.

Un dispositif de ce type est par exemple décrit dans le brevet britannique GB-A-1 603 648, sous la forme d'un compteur électronique d'énergie électrique dont les bornes de branchement en permettent le raccordement à un réseau d'énergie électrique, et qui comprend un circuit de mesure d'énergie constitué par un circuit intégré dont les bornes d'entrée sont reliées à ces bornes de branchement.

Comme le montrent celles des figures de ce brevet qui sont relatives à des modes de connexion différents, un tel compteur doit évidemment être adapté au type de réseau sur lequel il est destiné à être branché.

De façon générale, d'ailleurs, les dispositifs incorporant des circuits électroniques propres à mesurer un ou plusieurs paramètres électriques sont traditionnellement conçus pour fonctionner selon un mode de branchement unique, et risquent, s'ils sont utilisés de toute autre manière, de ne délivrer aucun signal, de ne fournir que des mesures fausses, ou même d'être détruits.

Un problème survient en particulier lorsqu'un dispositif du type défini dans le préambule a besoin de pouvoir être raccordé à un réseau électrique indifféremment par N+1 bornes de branchement, ou par N+2 bornes, c'est-à-dire avec le recours éventuel à une borne de branchement supplémentaire, lorsque la première borne et la borne supplémentaire sont alors susceptibles de se trouver au même potentiel ou à deux potentiels différents dont la différence représente une tension parasite, et lorsque néanmoins le circuit de mesure doit fournir une réponse insensible à la présence d'une telle tension parasite.

Dans ce contexte, la présente invention a essentiellement pour but d'apporter une solution à ce premier problème.

A cette fin, le dispositif de l'invention est essentiellement caractérisé en ce qu'en plus des éléments énoncés dans le préambule, il comprend :

- une borne de branchement supplémentaire, susceptible d'être sélectivement portée au potentiel de la première borne de branchement, ou à un potentiel différent,
- borne d'entrée supplémentaire constituant, avec la seconde borne d'entrée du circuit de mesure, une entrée différentielle pour ce circuit, et
- second diviseur de tension, installé entre la première borne de branchement et la borne de branchement supplémentaire, comportant un second point intermédiaire relié à la borne d'entrée supplémentaire du circuit de mesure, et introduisant un rapport de tensions sensiblement égal au rapport introduit par le premier diviseur,

la tension définie entre la seconde borne d'entrée et la borne d'entrée supplémentaire étant ainsi sensiblement représentative de la tension entre la seconde borne de branchement et la borne de branchement supplémentaire, que celle-ci soit ou non portée au même potentiel que la première borne de branchement.

Dans le cas où au moins deux bornes de branchement, incluant la première borne de branchement mais non la borne de branchement supplémentaire, définissent au moins une tension représentative d'un courant circulant dans un shunt, ce dispositif comprend avantageusement un transformateur d'alimentation dont le primaire est installé entre la borne de branchement supplémentaire et la seconde borne de branchement, et dont le secondaire est galvaniquement relié à la première borne de branchement.

Grâce à cette disposition, il est possible d'alimenter sur un banc de test plusieurs dispositifs de mesure à partir de l'énergie disponible entre deux des bornes de branchement de chacun de ces dispositifs sans pour autant perturber de façon sensible le courant circulant dans leurs shunts respectifs et ceci sans que la borne de branchement supplémentaire de chaque dispositif soit portée au même potentiel que la première borne de branchement.

Le dispositif de l'invention est particulièrement adapté au cas où le circuit de mesure est un circuit de mesure de puissance ou d'énergie électrique, et où ce dispositif est destiné à être installé sur un réseau d'énergie électrique comprenant au moins un conducteur de phase et un conducteur de neutre, les première et seconde bornes de branchement étant alors, en fonctionnement, avantageusement portées aux potentiels respectifs des conducteurs de phase et de neutre.

Dans ce cas, il est en outre préférable que les bornes de branchement portées à des potentiels dont la différence est représentative du courant circulant dans le shunt soient les première et troisième bornes.

Par ailleurs, l'impédance série du premier diviseur de tension est de préférence au moins égale à 500kohms, et le rapport de l'impédance série du premier diviseur de tension à celle du second diviseur est de préférence au moins égal à un.

Enfin, les avantages recherchés par l'invention sont d'autant mieux obtenus que ce rapport est proche d'une valeur fixe et prédéterminée, autrement dit qu'il reste sensiblement identique d'un dispositif à l'autre.

D'autres caractéristiques et avantages de l'invention ressortiront clairement de la description qui en est faite ci-après, à titre indicatif et nullement limitatif, en référence à un mode de réalisation particulier et au dessin annexé, sur lequel:

- La figure 1 est un schéma représentant un banc destiné à tester des compteurs électromécaniques d'énergie électrique;
- La figure 2 est un schéma représentant un compteur électronique d'énergie électrique, susceptible de bénéficier des avantages de l'invention; et
- La figure 3 est un schéma représentant un dispositif conforme à l'invention.

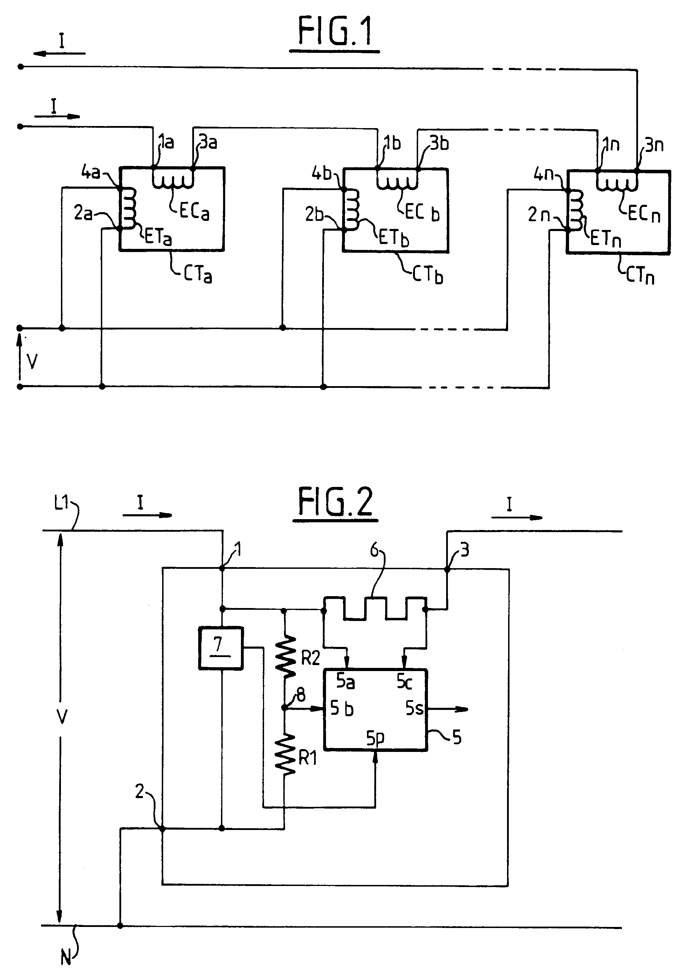

Un compteur électro-mécanique monophasé classique, tel que CTa, CTb, ou CTn (figure 1), comporte un enroulement courant tel que ECa, ECb, ou ECn, et un enroulement tension tel que ETa, ETb, ou ETn.

Un tel compteur se présente donc sous la forme d'un quadripôle, c'est-à-dire d'un dispositif doté de quatre bornes de branchement telles que 1a, 2a, 3a, 4a; 1b, 2b, 3b, 4b, etc.

De façon traditionnelle, ces compteurs sont testés par lots sur des bancs munis d'une source de courant I et d'une source de tension V, les enroulements de courant de plusieurs de ces compteurs étant branchés en série sur la source de courant et les enroulements de tension correspondants étant branchés en parallèle sur la source de tension.

Pour autant que les sources de courant et de tension du banc de test soient dimensionnées de façon adéquate, cette technique offre les meilleures garanties sur le plan métrologique, puisque tous les enroulements de courant de tous les compteurs sont traversés par le même courant, et que dans le même temps tous les enroulements de tension de ces mêmes compteurs sont soumis au même potentiel.

Cette technique suppose néanmoins que les bornes telles que 1a et 4a de chaque compteur puissent voir leurs potentiels respectifs évoluer de façon indépendante, faute de quoi les compteurs ne sont plus alors soumis aux mêmes signaux de courant selon qu'ils sont plus ou moins éloignés de la source de courant.

Une telle contrainte est notamment à l'origine du problème qui se pose pour tester, sans rien changer à la méthode de test ni au banc qui la met en oeuvre, un compteur électronique du type illustré sur la figure 2 et qui, comme le montre cette figure, est essentiellement constitué par un tripôle, c'est-à-dire par un dispositif doté de trois bornes de branchement seulement, telles que 1, 2 et 3.

Le compteur de la figure 2, décrit de façon détaillée dans le brevet GB 1 603 648 déjà précédemment cité, et simplement rappelé ici à titre d'exemple, comprend schématiquement un circuit électronique 5 de mesure d'énergie, un diviseur de tension R1, R2 installé entre les première et seconde bornes de branchement 1 et 2, un shunt 6 branché entre les première et troisième bornes 1 et 3, et un circuit d'alimentation électrique 7, lui aussi installé entre les première et seconde bornes de branchement 1 et 2.

Pour le fonctionnement de ce compteur sur le réseau d'énergie électrique, la seconde borne 2 est raccordée au conducteur de neutre N et les bornes 1 et 3 au conducteur actif de phase L1, le shunt 6 étant ainsi traversé par le courant circulant dans ce dernier conducteur.

Le diviseur de tension R1, R2 comporte deux résistances R1 et R2 d'inégales valeurs, dont la plus grande, R1, est reliée à la seconde borne 2.

De cette manière, le point intermédiaire 8 constitué par la borne commune aux résistances R1 et R2 est porté à un potentiel relativement proche de celui de la borne 1, mais dont la différence avec ce dernier est représentative de la tension entre les bornes 1 et 2, autrement dit entre les conducteurs L1 et N.

Le circuit de mesure 5 comprend essentiellement trois bornes d'entrée de mesure 5a, 5b, et 5c, respectivement reliées à la borne de branchement 1, au point intermédiaire 8, et à la borne 3, la tension reçue par le circuit 5 entre ses bornes 5a et 5c étant ainsi représentative du courant circulant dans le conducteur actif L1.

Par ailleurs, ce circuit comprend au moins une entrée d'alimentation électrique 5p, reliée à la sortie du circuit 7 qui lui fournit un potentiel sensiblement constant par rapport à celui de la première borne de branchement 1.

Le circuit 5, qui dispose donc d'une part, sur sa borne 5a, d'un potentiel qu'il peut utiliser comme potentiel de référence, qui dispose d'autre part, entre ses bornes 5a et 5b, d'une tension représentative de la tension entre les conducteurs L1 et N, et qui dispose enfin, entre ses bornes 5a et 5c, d'une tension représentative du courant qui traverse le conducteur L1, est ainsi en mesure de délivrer sur une sortie 5s un signal représentatif de la puissance ou de l'énergie circulant à travers les conducteurs L1 et N.

Si un tel compteur présente, à l'utilisation, de très nombreux avantages, notamment sur le plan de la prévention contre la fraude, il pose en revanche, avec les bancs de test traditionnels, un problème de branchement que le rapprochement des figures 1 et 2 fait immédiatement comprendre.

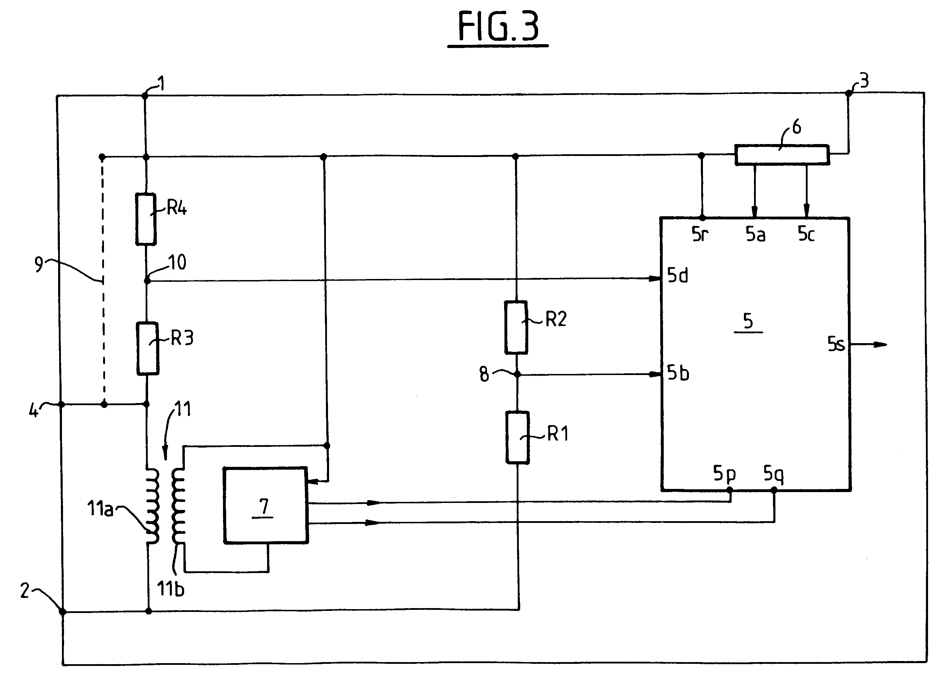

La figure 3 illustre un ensemble de mesures que l'invention propose de mettre en oeuvre pour résoudre le problème identifié dans le préambule, ainsi que des problèmes connexes spécifiques au comptage d'énergie électrique et au contexte des figures 1 et 2.

Pour des raisons de clarté, les éléments homologues apparaissant sur les figures 2 et 3 sont désignés par des chiffres de référence identiques.

En dehors des éléments déjà décrits en référence à la figure 2, le dispositif de la figure 3 comprend tout d'abord une borne de branchement supplémentaire 4, susceptible d'adopter un potentiel différent de celui de la borne 1, ou au contraire d'être portée au même potentiel que cette dernière grâce à un conducteur amovible 9 susceptible de relier ou non les bornes de branchement 1 et 4.

Comme le fera mieux comprendre la suite de la description, le conducteur amovible 9, qui peut prendre la forme d'une simple vis, est enlevé pour le passage du compteur sur le banc de test, et remis en place pour l'installation de ce compteur sur le réseau électrique.

Le circuit de mesure 5 comprend de son côté une borne d'entrée supplémentaire 5d qui constitue, avec la seconde borne d'entrée 5b, une entrée différentielle pour ce circuit de mesure.

L'expression "entrée différentielle" telle qu'utilisée ici est choisie pour indiquer que les bornes d'entrée 5b et 5d sont reliées aux entrées à haute impédance d'un amplificateur différentiel, ou tout au moins à l'étage d'entrée symétrique à deux transistors qui caractérise un tel amplificateur, lequel peut néanmoins préexister dans le circuit 5, comme c'est le cas pour le circuit de mesure décrit dans le brevet britannique déjà cité.

Le dispositif de l'invention comprend par ailleurs un second diviseur de tension R3, R4, installé entre la première borne de branchement et la borne de branchement supplémentaire, et composée de deux résistances d'inégales valeurs R3 et R4 dont la plus faible, R4, est reliée à la première borne de branchement.

Le point intermédiaire 10, qui est constitué par la borne commune aux résistances R3 et R4 et qui est relié à la borne d'entrée supplémentaire 5d du circuit de mesure 5 est ainsi porté, en l'absence du conducteur 9, à un potentiel relativement proche de celui de la borne 1, mais dont la différence avec ce dernier est représentative de la tension entre les bornes 1 et 4.

Plus précisément, le second diviseur de tension R3, R4 introduit un rapport de tensions sensiblement égal au rapport introduit par le premier diviseur, R1, R2, c'est-à-dire que le rapport (R4/R3) est aussi voisin que possible du rapport (R2/R1) et idéalement égal à ce dernier.

Dans ces conditions, et si l'on note $P_x$ le potentiel électrique de la borne de référence x, on peut montrer que :

$$P_{5b} - P_{5d} = k.(P_2 - P_4), \text{ où } k = R2/(R1 + R2) = R4/(R3 + R4)$$

Or il se trouve que, même lorsque les bornes 1 et 4 sont reliées par le conducteur 9, les bornes 1 et 2, donc les bornes 4 et 2, restent séparées par le premier diviseur de tension R1, R2, et que le calcul conduit à la même expression.

En d'autres termes, la tension appliquée sur l'entrée différentielle 5b, 5d du circuit de mesure 5 est donc représentative de la tension entre la seconde borne de branchement 2 et la borne de branchement supplémentaire 4, que cette dernière soit ou non portée au même potentiel que la première borne de branchement 1.

Dans une forme de réalisation industrielle et préférée de l'invention, les première et troisième bornes d'entrée 5a et 5c du circuit de mesure 5 sont en fait constituées par des bornes intermédiaires du shunt 6, auquel cas elles ne sont évidemment pas tout à fait aux potentiels respectifs des bornes de branchement 1 et 3, la tension aux bornes 5a et 5c étant de toute façon toujours représentative de la tension aux bornes 1 et 3. Dans ce mode de réalisation, tel qu'illustré, le circuit 5 comprend une borne d'entrée de référence de potentiel 5r, directement reliée à la première borne de branchement 1, et dont le potentiel, très proche de celui des bornes 5a et 5c, sert de référence interne de potentiel pour le circuit de mesure 5.

Selon une caractéristique très avantageuse de l'invention, un dispositif tel que celui de la figure 3 peut utiliser, pour alimenter le circuit de mesure 5 par l'énergie disponible entre les conducteurs 1 et 2, un transformateur d'alimentation 11 dont le primaire 11a est installé entre la borne de branchement supplémentaire 4 et la seconde borne de branchement 2, et dont le secondaire 11b est galvaniquement relié à la première borne de branchement 1.

La notion de liaison galvanique utilisée ici s'applique à deux conducteurs dont les potentiels électriques sont liés et évoluent de façon nécessairement coordonnée, par exemple parce que ces deux conducteurs sont reliés l'un à l'autre par un troisième, comme c'est le cas illustré sur le schéma de la figure 3.

Le secondaire 11b du transformateur d'alimentation 11 est relié à un convertisseur courant alternatif-courant continu classique 7, utilisant un pont redresseur et un filtre passe-bas et permettant, à partir du potentiel de référence de la borne 1 et de la tension alternative recueillie sur le secondaire 11b, de produire une tension continue bipolaire et stable, référencée par rapport au potentiel de la première borne de branchement 1, et que ce convertisseur 7 applique sur des entrées d'alimentation correspondantes 5p et 5q du circuit de mesure 5.

Le transformateur 11, qui ne sert qu'à produire un découplage galvanique, lorsque le conducteur 9 est ôté, entre la première borne 1 et la borne supplémentaire 4, pour fournir au circuit 5 une tension d'alimentation qui reste référencée par rapport au potentiel de la borne 1, et qui n'a besoin de présenter aucune qualité métrologique particulière, ni aucune qualité d'isolement très poussée, remplace très avantageusement les transformateurs de mesure très souvent utilisés dans l'art antérieur pour fournir aux circuits de mesure tels que 5 les signaux d'entrée sur les bornes telles que 5a, 5c, 5b et 5d.

Ainsi que l'homme de l'art pourra le vérifier sur la base de la description précédente, le potentiel moyen $(P_{5d}+P_{5b})/2$ présent sur l'entrée différentielle du circuit 5 est lié aux potentiels des bornes de branchement 1, 2 et 4 par la relation:

$$(P_{5d} + P_{5b})/2 = (1 - k).P_1 + k.(P_2 + P_4)/2,$$

de sorte que :

$$P_{5d} + P_{5b} - 2.P_1 = k.(P_2 + P_4 - 2.P_1)$$

En d'autres termes, le niveau moyen de tension $(P_{5d}+P_{5b}-2.P_1)/2$ reçu sur l'entrée différentielle 5d, 5b du circuit 5 n'est pas seulement fonction de la tension utile $P_2-P_1$, mais aussi de la tension parasite $P_4-P_1$ susceptible d'apparaître dès que le conducteur 9 a été ôté.

Il est donc a priori nécessaire de prendre des dispositions particulières pour remédier aux effets néfastes de l'apparition de cette tension de mode commun.

A posteriori, ces dispositions s'avèrent cependant relativement légères.

Tout d'abord, l'amplificateur différentiel à l'étage d'entrée duquel sont connectées les bornes 5b et 5d doit présenter un taux de réjection de mode commun suffisamment élevé.

En fait, un taux de réjection de l'ordre de 54dB, correspondant à un rapport 500/1, suffit à limiter à la valeur de 0.1% l'erreur relative engendrée par un signal de mode commun V/2 s'ajoutant à un signal différentiel V.

Par ailleurs, les rapports des diviseurs de tension R1, R2 d'une part, et R3, R4 d'autre part, doivent être appariés de manière à limiter l'écart relatif entre ces rapports et leur valeur théorique commune k.

A cette fin, l'un au moins de ces diviseurs peut être réalisé en technologie de couche épaisse, de manière à pouvoir être ajusté par un découpage au laser, l'erreur relative maximale tolérée sur ces rapports étant par exemple de l'ordre de 0.2%.

En pratique, il convient aussi de donner aux résistances en série R1+R2 d'une part et R3+R4 d'autre part des valeurs suffisamment élevées pour limiter la charge supportée par la source de tension du banc de test, une valeur de 500kohms pour R1+R2 et/ou R3+R4 étant cependant suffisante pour des tensions de service de l'ordre de 250 volts.

Par ailleurs, les exigences de réjection de mode commun peuvent être réduites en donnant au rapport R1/R3 (donc aussi au rapport R2/R4) une valeur au moins égale à l'unité.

Enfin, les avantages recherchés par l'invention sont d'autant mieux obtenus que le rapport (R1 + R2) / (R3 + R4) est proche d'une valeur fixe et prédéterminée, autrement dit qu'il reste sensiblement identique d'un dispositif à l'autre.

En effet cette dernière caractéristique, qui a pour corollaire que tous les compteurs d'un même lot de fabrication et testés sur un même banc présentent des rapports (R1 + R2) / (R3 + R4) très voisins et idéalement identiques, contribue à faire en sorte que tous les compteurs en cours de test reçoivent exactement les mêmes signaux de tension et de courant.

## Revendications

1. Dispositif de mesure électrique comprenant :
   - au moins N+1 bornes de branchement (1, 2, 3) dont les potentiels, en fonctionnement, définissent au moins N tensions pilotes, N étant un entier au moins égal à un;
   - un circuit électronique de mesure (5) comportant au moins N+1 bornes d'entrée (5a, 5b, 5c) dont les potentiels, en fonctionnement, définissent pour ce circuit au moins N tensions images représentatives de tensions pilotes correspondantes, ce circuit utilisant un potentiel de référence lié au potentiel de la première borne de branchement(1); et
   - un premier diviseur de tension (R1, R2), installé entre les première (1) et seconde (2) bornes de branchement, comportant un premier point intermédiaire (8) relié à la seconde borne d'entrée du circuit de mesure, et introduisant un rapport déterminé (k) de tensions,

   caractérisé en ce qu'il comprend en outre :
   - une borne de branchement supplémentaire (4), susceptible d'être sélectivement portée au potentiel de la première borne de branchement (1); ou à un potentiel différent,
   - une borne d'entrée supplémentaire (5d) constituant, avec la seconde borne d'entrée du circuit de mesure (5), une entrée différentielle pour ce circuit, et
   - un second diviseur de tension (R3, R4), installé entre la première borne de branchement (1) et la borne de branchement supplémentaire (4), comportant un second point intermédiaire (10) relié à la borne d'entrée supplémentaire (5d) du circuit de mesure, et introduisant un rapport de tensions (k) sensiblement égal au rapport introduit par le premier diviseur,

la tension définie entre la seconde borne d'entrée (5b) et la borne d'entrée supplémentaire (5d) étant ainsi sensiblement représentative de la tension entre la seconde borne de branchement (2) et la borne de branchement supplémentaire (4), que celle-ci soit ou non portée au même potentiel que la première borne de branchement (1).

2. Dispositif suivant la revendication 1, caractérisé en ce qu'au moins deux bornes de branchement (1, 3), incluant la première borne de branchement mais non la borne de branchement supplémentaire, définissent au moins une tension représentative d'un courant circulant dans un shunt (6), et en ce que, pour alimenter le circuit de mesure par l'énergie disponible entre au moins deux des bornes de branchement, ce dispositif comprend un transformateur d'alimentation (11) dont le primaire (11a) est installé entre la borne de branchement supplémentaire et la seconde borne de branchement, et dont le secondaire (11b) est galvaniquement relié à la première borne de branchement.

3. Dispositif suivant l'une quelconque des revendications précédentes, caractérisé en ce que le circuit de mesure est un circuit de mesure de puissance ou d'énergie électrique.

4. Dispositif suivant l'une quelconque des revendications précédentes, installé sur un réseau d'énergie électrique comprenant au moins un conducteur de phase (L1) et un conducteur de neutre (N), caractérisé en ce que les première et seconde bornes de branchement (1, 2) sont respectivement portées aux potentiels des conducteurs de phase et de neutre.

5. Dispositif suivant l'une quelconque des revendications précédentes, combinée à la revendication 2, caractérisé en ce que les bornes de branchement portées à des potentiels dont la différence est représentative du courant circulant dans le shunt sont les première et troisième bornes (1, 3).

6. Dispositif suivant l'une quelconque des revendications précédentes, caractérisé en ce que l'impédance série (R1+R2) du premier diviseur de tension est au moins égale à 500kohms.

7. Dispositif suivant l'une quelconque des revendications précédentes, caractérisé en ce que le rapport ((R1+R2)/(R3+R4)) de l'impédance série du premier diviseur de tension à celle du second diviseur est au moins égal à un.

8. Dispositif suivant la revendication 7, caractérisé en ce que ledit rapport des impédances série a une valeur fixe et prédéterminée.

**Patentansprüche**

1. Elektrische Meßanordnung, enthaltend:
   - wenigstens N+1 Anschlußklemmen (1, 2, 3), deren Potentiale im Betrieb wenigstens N Pilotspannungen definieren, wobei N eine ganze Zahl ist, die wenigstens gleich Eins ist;
   - eine elektronische Meßschaltung (5), die wenigstens N+1 Eingangsklemmen (5a, 5b, 5c) aufweist, deren Potentiale im Betrieb für diese Schaltung wenigstens N Bildspannungen definieren, die für entsprechende Pilotspannungen repräsentativ sind, wobei diese Schaltung ein Bezugspotential verwendet, das mit dem Potential der ersten Anschlußklemme (1) verknüpft ist;
   - einen ersten Spannungsteiler (R1, R2), der zwischen der ersten Anschlußklemme (1) und der zweiten Anschlußklemme (2) angeschlossen ist und einen ersten Zwischenpunkt (8) aufweist, der mit der zweiten Eingangsklemme der Meßschaltung verbunden ist, und der ein vorbestimmtes Spannungsverhältnis (k) einführt,

   dadurch gekennzeichnet, daß sie außerdem enthält:
   - eine zusätzliche Anschlußklemme (4), die wahlweise auf das Potential der ersten Anschlußklemme (1) oder auf ein anderes Potential gebracht werden kann,
   - eine zusätzliche Eingangsklemme (5d), die mit der zweiten Eingangsklemme der Meßschaltung (5) einen Differenzeingang für diese Schaltung bildet, und
   - einen zweiten Spannungsteiler (R3, R4), der zwischen der ersten Anschlußklemme (1) und der zusätzlichen Anschlußklemme (4) angeschlossen ist, und einen zweiten Zwischenpunkt (10) aufweist, der mit der zusätzlichen Eingangsklemme (5d) der Meßschaltung verbunden ist und ein Spannungsverhältnis (k) einführt, das im wesentlichen gleich dem von dem ersten Spannungsteiler eingeführten Spannungsverhältnis ist,

   wodurch die zwischen der zweiten Eingangsklemme (5b) und der zusätzlichen Eingangsklemme (5d) definierte Spannung im wesentlichen repräsentativ für die Spannung zwischen der zweiten Anschlußklemme (2) und der zusätzlichen Anschlußklemme (4) ist, unabhängig davon, ob diese auf das gleiche Potential wie die erste Anschlußklemme (5) gebracht ist oder nicht.

**2.** Anordnung nach Anspruch 1, dadurch gekennzeichnet, daß wenigstens zwei Anschlußklemmen (1, 3), die die erste Anschlußklemme, aber nicht die zusätzliche Anschlußklemme enthalten, wenigstens eine Spannung definieren, die für einen in einem Nebenschlußwiderstand (6) fließenden Strom repräsentativ ist, und daß zur Stromversorgung der Meßschaltung durch die Energie, die zwischen wenigstens zwei der Anschlußklemmen verfügbar ist, die Anordnung einen Speisetransformator (11) enthält, dessen Primärwicklung (11a) zwischen der zusätzlichen Anschlußklemme und der zweiten Anschlußklemme angeschlossen ist und deren Sekundärwicklung (11b) galvanisch mit der ersten Anschlußklemme verbunden ist.

**3.** Anordnung nach einem der vorhergehenden Ansprüche, dadurch gekennzeichnet, daß die Meßschaltung eine Meßschaltung für die elektrische Leistung oder die elektrische Energie ist.

**4.** Anordnung nach einem der vorhergehenden Ansprüche, die an ein elektrisches Energienetz angeschlossen ist, das wenigstens einen Phasenleiter (L1) und einen neutralen Leiter (N) aufweist, dadurch gekennzeichnet, daß die erste und die zweite Anschlußklemme (1, 2) auf das Potential des Phasenleiters bzw. auf das Potential des neutralen Leiters gebracht sind.

**5.** Anordnung nach einem der vorhergehenden Ansprüche in Verbindung mit Anspruch 2, dadurch gekennzeichnet, daß die Anschlußklemmen, die auf Potentiale gebracht sind, deren Differenz für den im Nebenschluß fließenden Strom repräsentativ ist, die erste und die dritte Klemme (1, 3) sind.

**6.** Anordnung nach einem der vorhergehenden Ansprüche, dadurch gekennzeichnet, daß die Serienimpedanz (R1+R2) des ersten Spannungsteilers wenigstens gleich 500 kΩ ist.

**7.** Anordnung nach einem der vorhergehenden Ansprüche, dadurch gekennzeichnet, daß das Verhältnis ((R1+R2)/(R3+R4)) der Serienimpedanz des ersten Spannungsteilers zu derjenigen des zweiten Spannungsteilers wenigstens gleich Eins ist.

**8.** Anordnung nach Anspruch 7, dadurch gekennzeichnet, daß das Verhältnis der Serienimpedanzen einen festen, vorbestimmten Wert hat.

**Claims**

**1.** An electrical measuring device comprising : at least N+1 connection terminals (1,2,3) whose potentials define, in operation, at least N control voltages, N being an integer at least equal to one;

an electronic measuring circuit (5) comprising at least N+1 input terminals (5a, 5b, 5c) whose potentials define for the circuit, in operation, at least N counterpart voltages representing the corresponding control voltages, this circuit using a reference potential linked to the potential of the first connection terminal (1); and

a first voltage divider (R1, R2) conected between the first (1) and second (2) connection terminals, with a first intermediate point (8) connected to the second input terminal of the measuring circuit, and providing a determined voltage ratio (k),

characterised in that it further comprises :

an additional connection terminal (4), adapted to be raised selectively to the potential of the first connection terminal (1) or to a different potential,

an additional input terminal (5d) co-operating with the second input terminal of the measuring circuit (5) to form a differential input for this circuit, and

a second voltage divider (R3, R4) connected between the first connection terminal and the additional connection terminal, comprising a second intermediate point (10) connected to the additional input terminal (5d) of the measuring circuit and providing a voltage ratio (k) substantially equal to the ratio provided by the first divider,

the voltage defined between the second input terminal (5b) and the additional input terminal (5d) thus being substantially representative of the voltage between the second connection terminal (2) and the additional connection terminal (4), whether this is raised to the same potential as the first connection terminal (1) or not.

**2.** A device according to claim 1, characterised in that at least two connection terminals (1,3), including the first connection terminal but not the additional connection terminal define at least one voltage representative of the current flowing in a shunt (6), and wherein, in order to power the measuring circuit from the power available between at least two of the connection terminals, the device includes a power supply transformer (11) whose primary (11a) is connected between the additional connection terminal and the second connection terminal and whose secondary (11b) is connected by a DC connection to this first connection terminal.

3. A device according to any one of the preceding claims, characterised in that the measuring circuit is a circuit measuring electrical energy or power.

4. A device according to any one of the preceding claims, connected in an electrical power network comprising at least one phase conductor (L1) and a neutral conductor (N), characterised in that the first and second connection terminals (1, 2) are raised respectively to the potentials of the phase and neutral conductors.

5. A device according to any one of the preceding claims and claim 2, characterised in that the connection terminals raised to potentials whose difference represents the current flowing in the shunt are the first and third terminals (1,3).

6. A device according to any one of the preceding claims, characterised in that the series impedance (R1+R2) of the first voltage divider is not less than 500 kohms.

7. A device according to any one of the preceding claims, characterised in that the ratio ((R1+R2)/(R3+R4)) of the series impedance of the first voltage divider and that of the second voltage divider is at least equal to one.

8. A device according to claim 7, characterised in that said ratio of series impedances has a fixed, perdetermined value.

## FIG.1

## FIG.2

# FIG.3

EP 0 490 711 B1